# EUROPÄISCHE PATENTSCHRIFT

(11) **EP 2 060 161 B1**
(45) Veröffentlichungstag und Bekanntmachung des Hinweises auf die Patenterteilung: **01.02.2012**
(21) Anmeldenummer: 07802826.3
(22) Anmeldetag: 23.08.2007
(51) Int. Cl.: H05K 5/00, H05K 9/00, B65D 81/07

(54) **TRANSPORTGEHÄUSE FÜR EINE ELEKTRONISCHE FLACHBAUGRUPPE**
TRANSPORT HOUSING FOR AN ELECTRONIC FLAT ASSEMBLY
BOÎTIER DE TRANSPORT POUR UN MODULE PLAT ÉLECTRONIQUE

(30) Priorität: 06.09.2006 DE 102006042417
(43) Veröffentlichungstag der Anmeldung: 20.05.2009
(73) Patentinhaber: SIEMENS AKTIENGESELLSCHAFT, 80333 München (DE)
(72) Erfinder: BOHNEN, Peter, 13437 Berlin (DE); MIHAILOVIC, Philip, 13359 Berlin (DE)
(86) Internationale Anmeldenummer: PCT/EP2007/058766
(87) Internationale Veröffentlichungsnummer: WO 2008/028820

(56) Entgegenhaltungen:
- DE-U1- 20 208 019
- US-A- 4 858 764
- US-A- 5 285 895

## Beschreibung

Die Erfindung bezieht sich auf ein Transportgehäuse zur Aufnahme einer elektronischen Flachbaugruppe.

Eine derartige elektronische Flachbaugruppe ist ein auch als System-in-Package (SiP) bezeichnetes Integrationssystem diskreter elektronischer Bauelemente auf einer Leiterplatte. Auf dieser ist häufig ein bedien- oder einstellbares elektronisches Bauelement in Form oder nach Art eines Dual-in-Package (DIP) Schalters oder Codier-Schalters, beispielsweise in Surface-Mounted-Device-Technik (SMD), montiert. Zudem ist die Flachbaugruppe häufig bereits schon vor deren Endmontage oder deren Endeinbau mit einer Anschlussleitung versehen.

Enthält die Flachbaugruppe ein gemäß der DIN EN 61340-5-1 empfindliches Bauteil (ESDS), d.h. ein diskretes Bauelement, eine integrierte Schaltung (IC) oder eine Baugruppe, das bzw. die mechanisch, durch elektrostatische Felder und/oder durch elektrostatische Entladung während routinemäßiger Handhabung, Prüfung und Transport beschädigt werden kann, so ist insbesondere auch zu Transportzwecken ein möglichst zuverlässiger Schutz des betroffenen ESDS-gefährdeten Bauteils oder der gesamten Flachbaugruppe wünschenswert.

Der Erfindung liegt daher die Aufgabe zugrunde, ein insbesondere für eine solche Flachbaugruppe geeignetes Transport- oder Schutzgehäuse anzugeben.

Diese Aufgabe wird erfindungsgemäß gelöst durch die Merkmale des Anspruchs 1. Hierzu weist das Transportgehäuse zwei die Flachbaugruppe aufnehmende Gehäusehälften auf, wobei die eine Gehäusehälfte zumindest teilweise in die andere Gehäusehälfte einschiebbar ist. Die Gehäusehälften sind mittels Formelementen in mindestens zwei Verschließstellungen miteinander verbindbar. Hierzu weisen die beiden Gehäusehälften eine Anzahl von gestaffelt angeordneten Formelementen zur Herstellung eines Formgesperres mit zwei in Verschließrichtung hintereinander angeordneten Rastpositionen auf.

Vorteilhafte Ausgestaltungen, Weiterbildungen und Varianten sind Gegenstand der Unteransprüche.

Das als Schutzgehäuse dienende Transportgehäuse eignet sich besonders zum mechanischen und/oder elektronischen bzw. elektrostatischen Schutz einer Flachbaugruppe in Form beispielsweise einer Leiterplatte, die sowohl mit einem DIP-Schalter für eine individuelle Gerätekodierung als auch mit einer Anschlussleitung versehen ist. Die zwei Gehäusehälften des Transportgehäuses nehmen die Flachbaugruppe auf und werden zweckmäßigerweise durch Ineinanderschieben geschlossen.

Die beiden Gehäusehälften sind dabei derart ausgestaltet, dass ein zumindest zweistufiges Verschließen des Gehäuses ermöglicht ist. In einer ersten Verschließposition ist das Transportgehäuse unter Freilassung eines Bedienfensters, insbesondere zur Betätigung des DIP-Schalters, noch unvollständig verschlossen. In dieser ersten Verschließposition ist der DIP-Schalter oder ein ähnliches Kodierelement von außen bedienbar, um über entsprechende Schaltelemente bestimmte, anwendungsspezifische Leiterbahnverbindungen oder -verknüpfungen auf der Leiterplatte der Flachbaugruppe herzustellen.

Die Bereitstellung des Bedienfensters wird zweckmäßigerweise dadurch erreicht, dass zumindest eine der Gehäusehälften eine Bedienöffnung aufweist, die beispielsweise in Form einer an einer Gehäuseseite vorgesehenen U-förmigen Gehäuseausnehmung gebildet ist. Die offene Seitenflanke dieser U-förmigen Gehäuseausnehmung wird dann durch eine entsprechende Gehäusekante der anderen Gehäusehälfte in der ersten Verschließstellung gebildet.

Anschließend kann das Transportgehäuse durch Verbringen der beiden Gehäusehälften in eine zweite Versschließstellung vollständig geschlossen werden. In der zweiten Verschließstellung ist das Transportgehäuse vorzugsweise unter Freilassung einer Durchgangsöffnung zur Herausführung der Anschlussleitung der Flachbaugruppe verschlossen. Dabei ist der Verschließmechanismus vorzugsweise derart ausgebildet, dass die beiden Gehäusehälften nicht mehr oder nur mit einem Spezialwerkzeug zum Öffnen des Transportgehäuses voneinander getrennt werden können.

Der Verschließmechanismus des Transportgehäuses ist vorteilhaft gebildet durch die an den beiden Gehäusehälften vorgesehenen und dort gestaffelt angeordneten Formelementen zur Herstellung des mehrstufigen Formgesperres. Dabei sind zweckmäßigerweise zwei in Verschließrichtung hintereinander angeordneten Rastpositionen für die beiden unterschiedlichen Verschließstellungen des Transportgehäuses vorgesehen.

In vorteilhafter Ausgestaltung sind die Formelemente durch an die Gehäusehälften angeformte Rasthacken und mit diesen korrespondierende Rastausnehmungen gebildet. Dabei sind die Rasthacken bevorzugt an derjenigen Gehäusehälfte vorgesehen, die in die andere Gehäusehälfte einschiebbar verschließbar ist. Demzufolge sind dann die Rastausnehmungen an derjenigen Gehäusehälfte vorgesehen, in die die andere Gehäusehälfte einschiebbar ist.

Die durch die Rasthacken gebildeten Formelemente sind in Verschließ- oder Verschieberichtung zueinander versetzt angeordnet. Dabei können die Rasthacken an unterschiedlichen Gehäuseseiten der entsprechenden Gehäusehälfte angeformt sein. Vorzugsweise sind jedoch die Rasthacken jeweils paarweise gestaffelt an gegenüberliegenden Gehäuseseiten vorgesehen. Dabei sind die Rasthacken in Querrichtung zur Verschließ- bzw. Verschieberichtung zueinander versetzt neben- oder übereinander angeordnet.

Analog sind die die Rastausnehmungen bildenden Formelemente wiederum vorzugsweise paarweise an gegenüberliegenden Seitenflächen der entsprechenden Gehäusehälfte vorgesehen und dort wiederum in Querrichtung zur Verschließrichtung neben- bzw. übereinander angeordnet.

Die in Verschließrichtung erste wirksame Rastausnehmung ist dabei derart ausgebildet, dass der mit dieser korrespondierende, in Verschließ- oder Verschieberichtung vordere Rasthacken entlang dieser Rastausnehmung verschiebbar ist, bis der nachgeordnete zweite Rasthacken in die korrespondierenden zweiten Rastausnehmung einrastet.

Für eine zuverlässige Schiebeführung sowie eine sichere Verrastung der beiden Gehäusehälften gegeneinander ist jeder Rasthacken mit einer in Verschließrichtung verlaufenden Anlaufschräge oder -rampe versehen, die in eine Rastkante oder einen Rastanschlag zur Ausbildung eines Hintergriffs mit einer korrespondierenden Anschlag- oder Rastfläche der entsprechenden Rastausnehmung mündet.

Der durch die gestaffelte Anordnung der Formelemente bereit gestellte Verschließmechanismus ermöglicht eine unvollständige erste Verschließstellung, in der die beiden Gehäusehälften mittels den in Verschließrichtung vorderen Formelementen in einer ersten Schnapp- oder Rastposition miteinander verrastet sind. Der Verschließmechanismus ermöglicht zudem eine vollständige zweite Verschließstellung. In dieser sind die in beiden Gehäusehälften über die in Verschließrichtung hinteren Formelemente in der zweiten Rastposition miteinander unter Ausbildung eines nicht oder nur unter zur Hilfenahme eines Spezialwerkzeugs lösbaren Form- oder Rastgesperres miteinander verbunden.

In dieser vollständigen Verschließstellung ist eine in einer der Gehäusehälften vorgesehene Durchgangsöffnung zum Herausführen der Anschlussleitung der Flachbaugruppe unverschlossen. In dieser vollständigen Verschließstellung bildet die Innenseite der Gehäuserückwand der einen Gehäusehälfte einen Anschlag für einen an der anderen Gehäusehälfte vorgesehenen Einschubabschnitt oder -schaft, über den die entsprechende Gehäusehälfte in die andere Gehäusehälfte einführbar ist.

In vorteilhafter Weiterbildung weist zumindest eine der beiden Gehäusehälften ein gehäuseaußenseitig vorgesehenes und dort vorzugsweise angeformtes Schnappelement auf, das eine Einlegeöse für eine Klemmhalterung ausbildet. Mittels dieses Schnappelementes kann das Transportgehäuse mit oder an einer Teilleitung eines übergeordneten Anschlusskabels, das auch die Anschlussleitung der Flachbaugruppe umfasst, schnapp- oder klemmfixiert werden.

Gemäß einer besonders zweckmäßigen Variante ist in Biegerichtung hinter dem feder- oder biegeelastischen Schnappelement ein Anschlagelement angeordnet, das den Biegehub des Schnappelementes bzw. dessen Schnapp- oder Rasthacken begrenzt. Bei einem durch zwei Rasthacken gebildeten Schnappelement ist zweckmäßigerweise jedem der Rasthacken auf der der Einlegöse abgewandten Hackenrückseite jeweils ein solches Anschlagelement zugeordnet. Dieses ist bevorzugt ebenso wie das Schnappelement selbst an einer Gehäuseaußenseite der jeweiligen Gehäusehälfte einstückig angeformt. Das somit als Hubbegrenzung dienende Anschlagelement verhindert ein Überbiegen und damit eine Beschädigung oder ein Abbrechen des entsprechenden Rasthackens oder Schnappelementes.

Die mit der Erfindung erzielten Vorteile bestehen insbesondere darin, dass durch eine gestaffelt angeordnete Verrastung eines aus zwei sich gegenseitig verschließenden Gehäusehälften aufgebauten Transportgehäuses ein vollständiger mechanischer und elektronischer oder elektrostatischer Schutz gemäß der eingangs genannten Norm einer Flachbaugruppe gewährleistet ist.

Zudem ermöglicht das zweiteilige Transportgehäuse eine Einstellmöglichkeit an der Flachbaugruppe auch noch nach einem Einbau in ein übergeordnetes Gerät. Anschließend kann das Transportgehäuse vollständig und ohne Spezialwerkzeug irreversibel geschlossen werden, so dass eine ungewünschte Manipulation der Einstellung beispielsweise des DIP-Schalters zuverlässig verhindert ist.

Mittels der zusätzlichen Schnappelemente mit Hubbegrenzung kann das eine vollständige Baugruppe bildende Transport- oder Schutzgehäuse zeitsparend und in einfacher Weise ohne Hilfsmittel an einer Geräteverdrahtung oder -verkabelung in Form beispielsweise eines Kabelbaums fixiert werden.

Das zwei- oder mehrteilige Gehäuse ist nicht nur für den Transport von derartigen Flachbaugruppen, insbesondere mit Anschlussleitungen, ESDS-empfindlichen Bauteilen und/oder DIP-Schaltern, verwendbar. Vielmehr eignet sich dieses aus zwei, vorzugsweise in gestaffelten Halte- oder Fixierpositionen miteinander verrastbaren Gehäusehälften aufgebaute Gehäuse allgemein als Umverpackung oder Schutzgehäuse für bestückte Leiterplatten und andere Geräte- oder Bauteile.

Auch ist die Anbringung oder Anformung eines Anschlagelementes in Biegerichtung hinter einem Schnappelement oder Rasthaken zur Begrenzung des Biegehubs unabhängig von dessen Verwendungszweck an einem solchen zweiteiligen Gehäuse oder Transportgehäuse bereits für sich allein vorteilhaft, wenn eine Beschädigung oder ein Abbrechen eines solchen Schnappelementes bzw. ein solchen Rasthakens, insbesondere bei häufiger Beanspruchung oder in rauer Umgebung, möglichst zuverlässig verhindert werden soll.

Nachfolgend wird ein Ausführungsbeispiel der Erfindung anhand einer Zeichnung näher erläutert. Darin zeigen:
- FIG 1: in perspektivischer Darstellung ein Transportgehäuse mit zwei unverschlossenen Gehäusehälften,
- FIG 2: das Transportgehäuse gemäß FIG 1 in einer ersten Verschließstellung,
- FIG 3: das Transportgehäuse gemäß FIG 1 in einer zweiten Verschließstellung,
- FIG 4: in perspektivischer Darstellung eine von dem Transportgehäuse aufzunehmende Flachbaugruppe mit einem DIP-Schalter und einer Anschlussleitung, und
- FIG 5: das an einem Kabelbaum klemmfixierte Transportgehäuse mit herausgeführter Anschlussleitung.

Einander entsprechende Teile sind in allen Figuren mit den gleichen Bezugszeichen versehen.

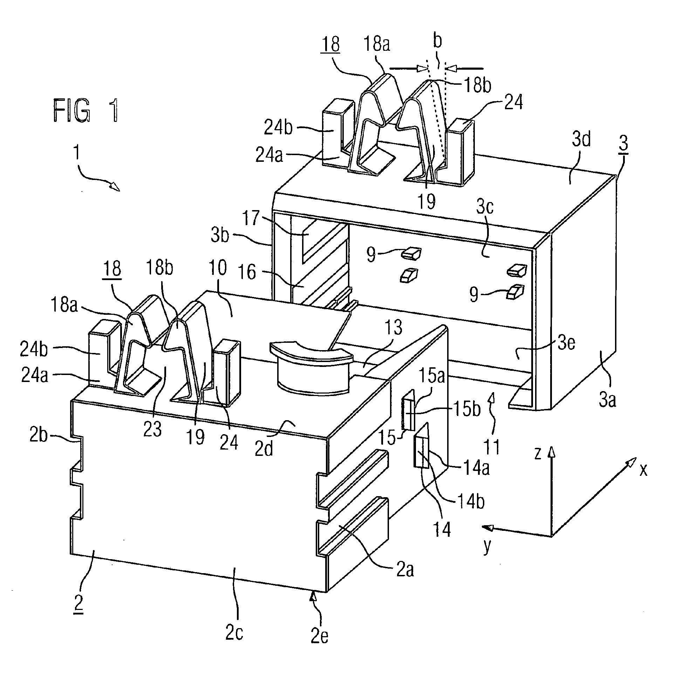

Die FIG 1 bis 3 zeigen ein Transport- oder Schutzgehäuse 1 mit zwei vorzugsweise aus Kunststoff bestehende Gehäusehälften 2,3. Diese sind bezogen auf das dargestellte Koordinatensystem in der in x-Richtung verlaufenden Verschließ- oder Verschieberichtung durch Einschieben der einen Gehäusehälfte 2 in die andere Gehäusehälfte 3 gegeneinander verschließbar.

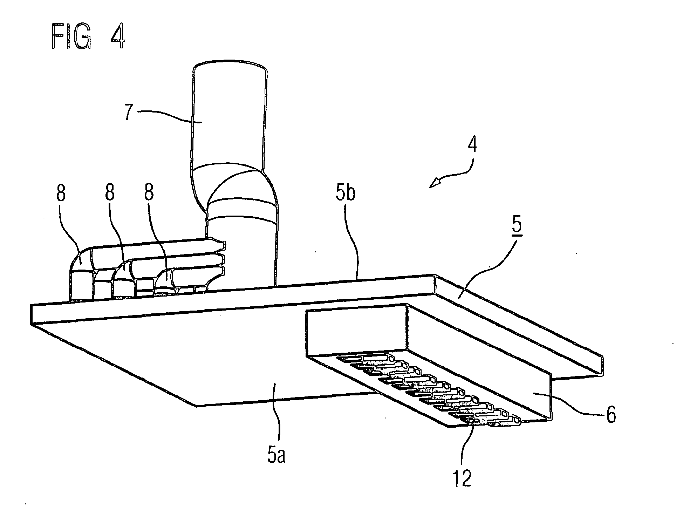

Das dargestellte Transportgehäuse 1 dient zur Aufnahme einer in FIG 4 dargestellten Flachbaugruppe 4. Die Flachbaugruppe 4 umfasst eine Leiterplatte 5 und einen DIP-Schalter 6 sowie eine Anschlussleitung oder ein Anschlusskabel 7. In der Darstellung gemäß FIG 4 ist der DIP-Schalter 6 auf der Unterseite 5a der Leiterplatte 5 beispielsweise in SMD-Technik montiert. Die Anschlussleitung 7 ist mit deren Leiteradern 8 auf der gegenüberliegenden Oberseite 5a in nicht näher dargestellter Art und Weise mit Leiterbahnen der Leiterplatte 5 elektrisch kontaktiert. Die Flachbaugruppe 4 kann zunächst die erste Gehäusehälfte 2 eingesetzt werden, die dann anschließend mit der zweiten Gehäusehälfte 3 verschlossen wird.

Die erste Gehäusehälfte 2 des Transportgehäuses 1 umfasst zwei einander gegenüberliegende Gehäuseschmalseiten 2a,2b und eine nachfolgend auch als Gehäuserückwand bezeichnete Gehäuserückseite 2c sowie eine Gehäuseoberseite 2d und eine Gehäuseunterseite 2e. Analog weist die zweite Gehäusehälfte 3 zwei einander gegenüberliegende Gehäuseschmalseiten 3a, 3b und eine nachfolgend auch als Gehäuserückwand bezeichnete Gehäuserückseite 3c sowie eine Gehäuseoberseite 3d und eine Gehäuseunterseite 3e auf.

An die Gehäuserückwand 3d der Gehäusehälfte 3 sind gehäuseinnenseitig Positionier- oder Haltezapfen 9 zur Lagefixierung der Flachbaugruppe 4 angeformt. Analog sind (nicht sichtbare) Lage- oder Positionierzapfen gehäuseinnenseitig an die Gehäuserückwand 2c der ersten Gehäusehälfte 2 angeformt. Mittels dieser paarweise einander gegenüberliegenden Positionierzapfen 9 wird die Flachbaugruppe 4 über eine Drei- oder Vierpunktlagerung innerhalb des Transportgehäuses 1 gehalten und lagefixiert. Dazu wird die Flachbaugruppe 4 zunächst beispielsweise in die erste Gehäusehälfte 2 eingeführt, die dann unter Einführen der Flachbaugruppe 4 zwischen die Positionierzapfen 9 mittels der zweiten Gehäusehälfte 3 verschlossen wird.

Das Verschließen des Transportgehäuses 1 erfolgt durch Ineinanderschieben der beiden Gehäusehälften 2,3. Dazu weist die Gehäusehälfte 2 einen Einschub- oder Einführabschnitt 10 auf, dessen äußere Umfangsabmessung an die innere Umfangsabmessung der Gehäusehälfte 3 angepasst ist.

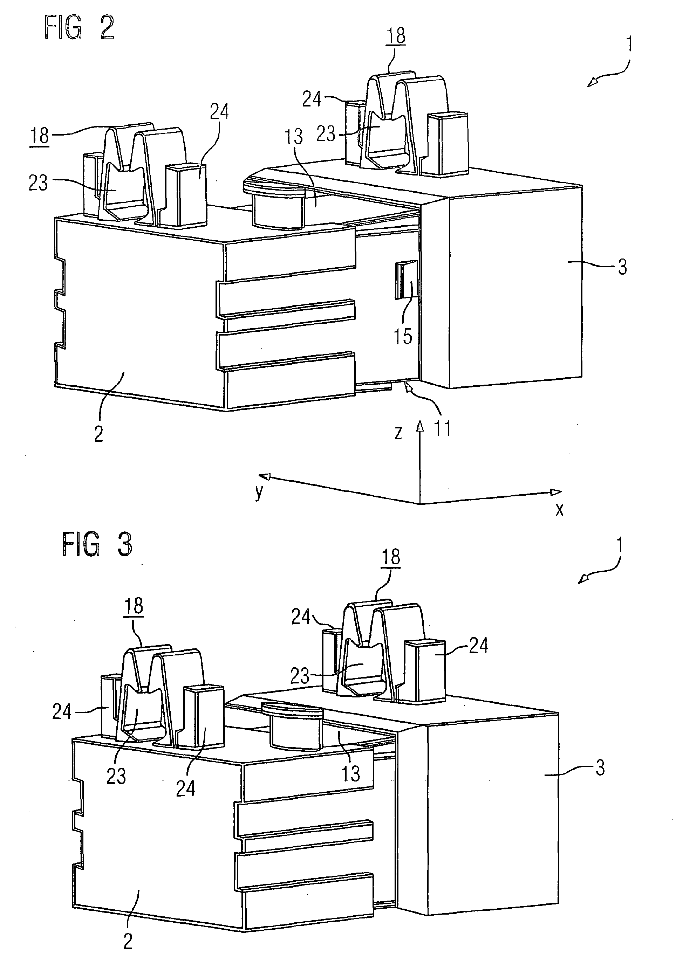

Das Verschließen der beiden Gehäusehälften 2,3 erfolgt in zwei in Verschließ- oder Einschubrichtung X aufeinanderfolgende Verschließstellungen. Dabei ist in der in FIG 2 angedeuteten ersten Verschließstellung das Transportgehäuse 1 noch unvollständig verschlossen. In dieser ersten Verschließstellung bleibt eine in der zweiten Gehäusehälfte 3 an deren Gehäuseunterseite 3e vorgesehene Bedienöffnung 11 nach Art eines Bedienfensters offen. Über dieses, in der ersten Verschließposition gemäß FIG 2 noch nicht verschlossene Bedienfenster 11 ist der DIP-Schalter 6 der Flachbaugruppe 4 zugänglich. Dadurch kann der DIP-Schalter 6 für eine individuellen Gerätecodierung über dessen Schiebetasten oder Einstellelemente 12 eingestellt werden, um beispielsweise definierte Verbindungen oder Verknüpfungen von Leiterbahnen der Leiterplatte 5 herzustellen.

Im Anschluss an eine erfolgte Bedienung oder Betätigung des DIP-Schalters 6 wird das Transportgehäuse 1 durch Verbringen der beiden Gehäusehälften 2,3 in die in FIG 3 dargestellte zweite Verschließstellung vollständig geschlossen.

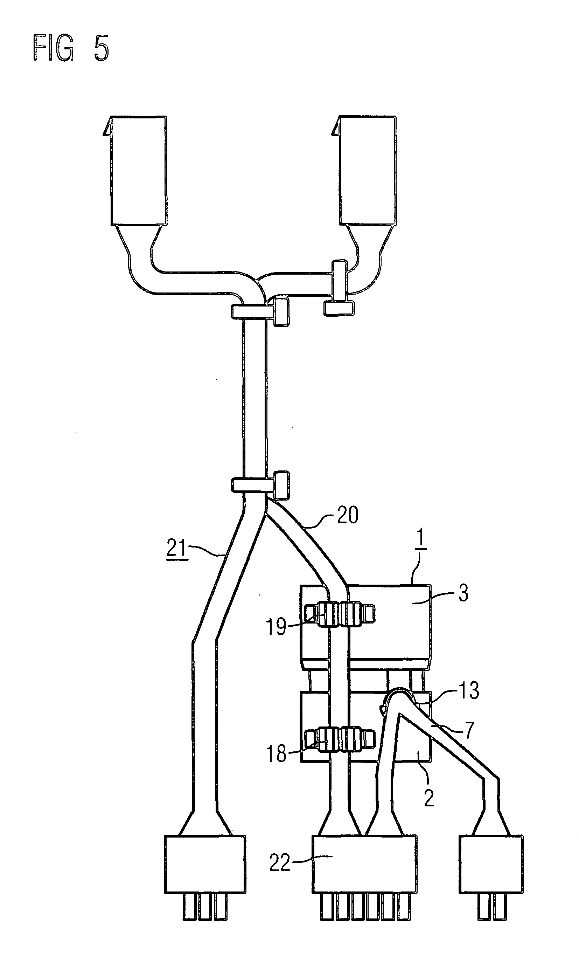

Wie aus den FIG 3 und 5 ersichtlich ist, verbleibt auch in dieser zweiter Verschließstellung der beiden Gehäusehälften 2,3 eine an der Gehäuseoberseite 2d der Gehäusehälfte 2 vorgesehene Durchgangsöffnung 13 zur Herausführung der Anschlussleitung bzw. des Anschlusskabels 7 der Flachbaugruppe 4 unverschlossen.

Zur Herstellung der beiden Verschließstellungen des Transportgehäuses 1 sind an den beiden Gehäusehälften 2,3 miteinander korrespondierende Formelemente zur Herstellung eines Form- oder Rastgesperres vorgesehen. Hierzu sind an den einander gegenüberliegenden Schmalseiten 2a,2b der Gehäusehälfte 2 im Bereich deren Einschubabschnitt 10 zwei Rasthacken 14,15 vorgesehen. Die beiden Rasthacken 14,15 sind - ebenso wie die nicht sichtbaren Rasthacken auf der gegenüberliegenden Gehäuseschmalseite 2b - in Verschließ- oder Verschieberichtung X gestaffelt hintereinander und dabei sowohl in X-Richtung als auch in der hierzu rechtwinklig verlaufenden Querrichtung Z zueinander versetzt angeordnet. Die Rasthacken 14,15 sind außenseitig an die Gehäuseschmalseiten 2a der Gehäusehälfte 2 angeformt und weisen jeweils eine Ein- oder Anlaufschräge 14a, 15a und eine Rastkante 14b bzw. 15b auf. Mit dieser Rastkante 14b, 15b hintergreifen die Rasthacken 14,15 korrespondierende Rastausnehmungen 16 bzw. 17, die jeweils auf der gleichen Gehäuseschmalseite 3a,3b der Gehäusehälfte 3 innenoder innenwandseitig vorgesehen sind. Die Rastausnehmungen 16,17 erstrecken sich ebenfalls in Verschieberichtung X.

In der in FIG 2 gezeigten ersten Verschließrichtung des Transportgehäuses 1 sind die in Verschließrichtung X vorderen (unteren) Rasthacken 14 mit der jeweils korrespondierenden Rastausnehmung 16 verrastet. In dieser ersten Verschließ- oder Rastposition, in der das Bedienfenster 11 noch für eine individuelle Codierung des DIP-Schalters 6 offen ist, sind die in Verschließrichtung X hinteren Rasthacken 15 noch nicht mit deren korrespondierenden Rastausnehmungen 17 verrastet.

Eine Verrastung auch dieser Formelemente 15, 17 erfolgt zur Herstellung der zweiten Rastposition und damit der zweiten Verschließstellung (FIG 3). In dieser Position der beiden Gehäusehälften 2,3 zueinander, in der das Transportgehäuse 1 lediglich unter Freilassung der Durchgangsöffnung 13 zum Herausführen der Anschlussleitung 7 der Flachbaugruppe 4 vollständig geschlossen ist, ist auch das Bedienfenster 11 verschlossen. In dieser vollständig verschlossenen Verschließstellung, in der die Formelemente 15, 17 miteinander verrastet sind, dient die Gehäuserückwand 3c als Einschubanschlag für die über den Einschubabschnitt 10 in die Gehäusehälfte 3 eingeschobene Gehäusehälfte 2.

Jede Gehäusehälfte 2,3 weist ein Schnappelement 18 auf. Die Schnappelemente 18 dienen zur Klemmfixierung des Transportgehäuses 1 an einem übergeordneten Anschlusskabel 20 eines Kabelbaumes oder eines Leitungsnetzes 21. Diesem ist über einen Steckkontakt oder ein Kontaktgehäuse 22 auch die Anschlussleitung 7 der in dem Transportgehäuse 1 angeordneten Flachbaugruppe 4 zugeordnet.

Die Schnappelemente 18 sind jeweils durch zwei einander gegenüberstehende Rasthacken 18a,18b gebildet, die eine Einlegeöse 23 zur Aufnahme des Anschlusskabel 20 begrenzen. Jedem Schnappelement 18 bzw. jedem der Rasthacken 18a,18b ist ein Anschlagelement 24 zur Hubbegrenzung zugeordnet. Das jeweilige Anschlagelement 24 ragt domartig in Z-Richtung aus der Gehäuseoberseite 2d,3d der jeweiligen Gehäusehälfte 2 bzw. 3 empor und ist auf der der Einlegeöse 23 abgewandten Hackenrückseite 19 des jeweiligen Schnappelementes 18 bzw. Rasthackens 18a,18b angeordnet. Sowohl die Schnappelemente 18 als auch die Anschlagelemente 24 sind wiederum vorzugsweise an die jeweilige Gehäusehälfte 2 bzw. 3 einstückig angeformt.

Die Anschlagelemente 24 sind in zweckmäßiger Ausgestaltung L-förmig ausgebildet, wobei der vergleichsweise kurze L-Schenkel 24a praktisch spaltlos an der Hackenrückseite 19 des jeweiligen Rasthackens 18a,18b anliegt. Dem gegenüber ist der vergleichsweise lange L-Schenkel 24b des Anschlagelementes 24 zur entsprechenden Hackenrückseite 19 beabstandet. Der entsprechende Abstand definiert somit für den entsprechenden Rasthackens 18a,18b und damit für das jeweilige Schnappelementes 18 den in Biegerichtung Y möglichen Biegehub b, der hinsichtlich einer zerstörungssicheren Biegebelastung des jeweiligen Rasthackens 18a,18b entsprechend bemessen oder ausgelegt ist.

### Bezugszeichenliste

- 1: Transportgehäuse
- 2: erste Gehäusehälfte
- 3: zweite Gehäusehälfte
- 2a,b: Gehäuseseitenwand
- 2c: Gehäuserückwand
- 2d: Gehäuseoberseite
- 2e: Gehäuseunterseite
- 3a,b: Gehäuseseitenwand
- 3c: Gehäuserückwand
- 3d: Gehäuseoberseite
- 3e: Gehäuseunterseite
- 4: Flachbaugruppe
- 5: Leiterplatte
- 5a: Plattenunterseite
- 5b: Plattenoberseite
- 6: DIP-Schalter
- 7: Anschlussleitung/-kabel
- 8: Leiteradern
- 9: Halte-/Positionierzapfen
- 10: Einschubabschnitt
- 11: Bedienöffnung/-fenster
- 12: Schiebetaste/Einstellelement
- 13: Durchgangsöffnung
- 14: Formelement/Rasthacken
- 14a: Ein-/Anlaufschräge
- 14b: Rastkante
- 15: Formelement/Rasthacken
- 15a: Ein-/Anlaufschräge
- 15b: Rastkante
- 16,17: Formelement/Rastausnehmung
- 18: Schnappelement
- 18a,b: Rasthacken
- 19: Hackenrückseite
- 20: Anschlusskabel
- 21: Kabelbaum/Leitungsnetz
- 22: Kontaktgehäuse/-stecker
- 23: Einlegeöse
- 24: Anschlagelement
- 24a: kurzer L-Schenkel
- 24b: langer L-Schenkel

- b: Biegehub
- x: Verschließ-/Verschieberichtung
- y: Biegerichtung
- Z: Querrichtung

## Patentansprüche

1. Transportgehäuse (1) zur Aufnahme einer elektronischen Flachbaugruppe (4), insbesondere mit mindestens einem bedienbaren elektronischen Bauelement in Form eines DIP-Schalters (6) und einer Anschlussleitung (7), mit zwei die Flachbaugruppe (4) aufnehmenden Gehäusehälften (2,3),
- wobei die eine Gehäusehälfte (2) zumindest teilweise in die andere Gehäusehälfte (3) einschiebbar ist, und
- wobei die beiden Gehäusehälften (2,3) zu deren Verbindung in mindestens zwei Verschließstellungen eine Anzahl von gestaffelt angeordneten Formelementen (14 bis 17) zur Herstellung eines Formgesperres mit zwei in Verschließrichtung (x) hintereinander angeordneten Rastpositionen aufweisen.

2. Transportgehäuse (1) nach Anspruch 1, **dadurch gekennzeichnet, dass** eine der beiden Gehäusehälften (3) eine verschließbare Bedienöffnung (11), insbesondere zur Betätigung eines auf die Flachbaugruppe (4) montierten DIP-Schalters (6), aufweist.

3. Transportgehäuse (1) nach Anspruch 1 oder 2, **dadurch gekennzeichnet, dass** eine der Gehäusehälften (2) eine unverschließbare Durchgangsöffnung (13), insbesondere zur Herausführung einer Anschlussleitung (7) der Flachbaugruppe (4), aufweist.

4. Transportgehäuse (1) nach einem der Ansprüche 1 bis 3, **dadurch gekennzeichnet, dass** die Formelemente (14 bis 17) in Querrichtung (z) zur Verschieberichtung (x) zueinander versetzt an jeweils dieselbe Gehäuseseite (2a,2b; a,3b) angeformt sind.

5. Transportgehäuse (1) nach einem der Ansprüche 1 bis 4, **gekennzeichnet durch** mindestens zwei an einer der beiden Gehäusehälften (2) vorgesehene und in Verschließrichtung (x) hintereinander angeordnete Rasthaken (14,15) sowie zwei mit diesen korrespondierende Rastausnehmungen (16,17) an der anderen Gehäusehälfte (3).

6. Transportgehäuse (1) nach Anspruch 5, **dadurch gekennzeichnet, dass** die in Verschließrichtung (x) erste wirksame Rastausnehmung (16) derart ausgebildet ist, dass der korrespondierende erste Rasthaken (14) entlang dieser Rastausnehmung (16) bis zur Verrastung des nachgeordneten zweiten Rasthakens (15) mit der zweiten Rastausnehmung (17) verschiebbar geführt ist.

7. Transportgehäuse (1) nach Anspruch 5 oder 6, **dadurch gekennzeichnet, dass** die Rasthaken (14,15) eine sich in Verschließrichtung (x) erstreckende Anlaufschräge (14a, 15a) und einen dieser gegenüberliegenden Rastanschlag (14b, 15b) zur Bildung eines Hintergriffs mit der korrespondierenden Rastausnehmungen (16,17) aufweisen.

8. Transportgehäuse (1) nach einem der Ansprüche 1 bis 7, **dadurch gekennzeichnet, dass** die zweite Gehäusehälfte (3) die erste Gehäusehälfte (2) in einer ersten Rastposition, insbesondere unter Freilassung einer Bedienöffnung (11) zur Betätigung eines auf die Flachbaugruppe (4) montierten DIP-Schalters (6), unvollständig und in der zweiten Rastposition, insbesondere unter Herausführung einer Anschlussleitung (7) der Flachbaugruppe (4), vollständig verschließt.

9. Transportgehäuse (1) nach einem der Ansprüche 1 bis 8, **dadurch gekennzeichnet, dass** eine der Gehäusehälften (2) einen in die andere Gehäusehälfte (3) einführbaren Einschubabschnitt (10) aufweist, wobei die Gehäuserückwand (3c) der anderen Gehäusehälfte (3) in der zweiten Rastposition als Einschubanschlag wirksam ist.

10. Transportgehäuse (1) nach einem der Ansprüche 1 bis 9, **dadurch gekennzeichnet, dass** die eine und/oder die andere Gehäusehälfte (2,3) ein in eine Biegerichtung (y) feder- oder biegeelastisches Schnappelement (18,19) mit einer Einlegeöse (23) für eine Klemmifixierung, insbesondere an einem mit der Anschlussleitung (7) der Flachbaugruppe (4) verbundenen Anschlusskabel (21), aufweist.

11. Transportgehäuse (1) nach Anspruch 10, **gekennzeichnet durch** ein in Biegerichtung (y) hinter dem Schnappelement (18,19) angeordnetes Anschlagelement (24) zur Begrenzung des Biegehubs (b) des Schnappelementes (18,19).

12. Transportgehäuse (1) nach Anspruch 10 oder 11, **dadurch gekennzeichnet, dass** das Schnappelement (18) durch zwei einander gegenüberstehende und die Einlegeöse (23) begrenzende Rasthaken (18a,18b) gebildet ist.

13. Transportgehäuse (1) nach Anspruch 12, **dadurch gekennzeichnet, dass** jedem Rasthaken (18a,18b) des Schnappelementes (18) auf der der Einlegeöse (23) abgewandten Hakenrückseite (19) jeweils ein Anschlagelement (24) zugeordnet ist.

14. Transportgehäuse (1) nach einem der Ansprüche 10 bis 13, **dadurch gekennzeichnet, dass** das Schnappelement (18) und/oder das Anschlagelement (24) an die jeweilige Gehäusehälfte (2,3) angeformt ist.

## Claims

1. Transport housing (1) for accommodating an electronic printed circuit board assembly (4), in particular having at least one electronic component, which can be operated, in the form of a DIP switch (6), and a connection line (7), having two housing halves (2, 3) which accommodate the printed circuit board assembly (4),
- it being possible to insert one housing half (2) at least partially into the other housing half (3), and
- the two housing halves (2, 3), in order to be connected in at least two closed positions, having a number of staggered shaped elements (14 to 17) for producing a positive locking arrangement with two latching positions which are arranged one behind the other in the closing direction (x).

2. Transport housing (1) according to Claim 1, **characterized in that** one of the two housing halves (3) has a closable operator control opening (11), in particular for operating a DIP switch (6) which is mounted on the printed circuit board assembly (4).

3. Transport housing (1) according to Claim 1 or 2, **characterized in that** one of the housing halves (2) has an uncloseable passage opening (13), in particular for leading out a connection line (7) of the printed circuit board assembly (4).

4. Transport housing (1) according to one of Claims 1 to 3, **characterized in that** the shaped elements (14 to 17) are integrally formed on in each case the same housing side (2a, 2b; 3a, 3b) in a manner offset in relation to one another in the transverse direction (z) to the movement direction (x).

5. Transport housing (1) according to one of Claims 1 to 4, **characterized by** at least two latching hooks (14, 15) which are provided on one of the two housing halves (2) and are arranged one behind the other in the closing direction (x), and also two latching recesses (16, 17), which correspond to said latching hooks, on the other housing half (3).

6. Transport housing (1) according to Claim 5, **characterized in that** the active latching recess (16) which is first in the closing direction (x) is formed in such a way that the corresponding first latching hook (14) is moveably routed along this latching recess (16) until the downstream second latching hook (15) latches with the second latching recess (17).

7. Transport housing (1) according to Claim 5 or 6, **characterized in that** the latching hooks (14, 15) have a run-on slope (14a, 15a), which extends in the closing direction (x), and a latching stop (14b, 15b), which is situated opposite the said run-on slope, for forming an undercut with the corresponding latching recesses (16, 17).

8. Transport housing (1) according to one of Claims 1 to 7, **characterized in that** the second housing half (3) incompletely closes the first housing half (2) in a first latching position, in particular so as to leave free an operator control opening (11) for operating a DIP switch (6) which is mounted on the printed circuit board assembly (4), and completely closes the said first housing half in the second latching position, in particular so as to lead out a connection line (7) of the printed circuit board assembly (4).

9. Transport housing (1) according to one of Claims 1 to 8, **characterized in that** one of the housing halves (2) has an insert section (10) which can be inserted into the other housing half (3), the housing rear wall (3c) of the other housing half (3) acting as an insert stop in the second latching position.

10. Transport housing (1) according to one of Claims 1 to 9, **characterized in that** one and/or the other housing half (2, 3) have/has a snap-action element (18, 19), which is spring elastic or flexible in a bending direction (y), having an insertion eye (23) for a clamping fixing operation, in particular to a connection cable (21) which is connected to the connection line (7) of the printed circuit board assembly (4).

11. Transport housing (1) according to Claim 10, **characterized by** a stop element (24), which is arranged downstream of the snap-action element (18, 19) in the bending direction (y), for limiting the bending travel (b) of the snap-action element (18, 19).

12. Transport housing (1) according to Claim 10 or 11, **characterized in that** the snap-action element (18) is formed by two latching hooks (18a, 18b) which are situated opposite one another and delimit the insertion eye (23).

13. Transport housing (1) according to Claim 12, **characterized in that** each latching hook (18a, 18b) of the snap-action element (18) has an associated stop element (24) on that hook rear face (19) which is averted from the insertion eye (23).

14. Transport housing (1) according to one of Claims 10 to 13, **characterized in that** the snap-action element (18) and/or the stop element (24) are/is integrally formed on the respective housing half (2, 3).

## Revendications

1. Boîtier ( 1 ) de transport pour la réception d'un module ( 4 ) électronique plat, ayant notamment au moins un composant électronique pouvant être commandé et sous la forme d'un commutateur ( 6 ) DIP et une ligne ( 7 ) de connexion, comprenant deux demi-boîtiers ( 2, 3 ) recevant le module ( 4 ) plat,
- dans lequel l'un des demi-boîtiers ( 2 ) peut être inséré au moins en partie dans l'autre demi-boîtier ( 3 ) et,
- dans lequel les deux demi-boîtiers ( 2, 3 ) ont pour leur liaison, en au moins deux positions de fermeture, un certain nombre d'éléments ( 14 à 17 ) de forme disposés de manière échelonnée pour ménager un encliquetage de forme ayant deux positions d'encliquetage disposées l'une derrière l'autre dans la direction ( x ) de fermeture.

2. Boîtier ( 1 ) de transport suivant la revendication 1, **caractérisé en ce que** l'un des deux demi-boîtiers ( 3 ) a une ouverture ( 11 ) de commande, qui peut être fermée, notamment pour l'actionnement d'un commutateur ( 6 ) DIP monté sur le module ( 4 ) plat.

3. Boîtier ( 1 ) de transport suivant la revendication 1 ou 2, **caractérisé en ce que** l'un des demi-boîtiers ( 2 ) a une ouverture ( 13 ) traversante, qui ne peut pas être fermée, notamment pour la sortie d'une ligne ( 7 ) de connexion du module ( 4 ) plat.

4. Boîtier ( 1 ) de transport l'une des revendications 1 à 3, **caractérisé en ce que** les éléments ( 14 à 17 ) de forme sont formés en étant décalés les uns par rapport aux autres dans la direction ( z ) transversale à la direction ( x ) d'insertion sur respectivement la même face ( 2a, 2b ; a, 3b ) du boîtier.

5. Boîtier ( 1 ) de transport l'une des revendications 1 à 4, **caractérisé par** au moins deux crochets ( 14, 15 ) d'encliquetage prévus sur l'un des deux demi-boîtiers ( 2 ) et disposés l'un derrière l'autre dans la direction ( x ) de fermeture ainsi que par deux évidements ( 16, 17 ) d'encliquetage leur correspondant sur l'autre demi-boîtier ( 3 ).

6. Boîtier ( 1 ) de transport suivant la revendication 5, **caractérisé en ce que** l'évidemment ( 16 ) d'encliquetage efficace le premier dans la direction ( x ) de fermeture est tel que le premier crochet ( 14 ) d'encliquetage correspondant est guidé à coulissement le long de cet évidement d'encliquetage jusqu'à l'encliquetage du deuxième crochet ( 15 ) d'encliquetage venant ensuite avec le deuxième évidemment ( 17 ) d'encliquetage.

7. Boîtier ( 1 ) de transport suivant la revendication 5 ou 6, **caractérisé en ce que** les crochets ( 14, 15 ) d'encliquetage ont un biseau ( 14a, 15a ) d'attaque s'étendant dans la direction ( x ) de fermeture et une butée ( 14b, 15b ) d'encliquetage opposée à ce biseau pour la formation d'une prise avec les évidements ( 16, 17 ) d'encliquetage correspondants.

8. Boîtier ( 1 ) de transport l'une des revendications 1 à 7, **caractérisé en ce que** le deuxième demi-boîtier ( 3 ) ne ferme pas complètement le premier demi-boîtier ( 2 ) dans une première position d'encliquetage, en laissant notamment une ouverture ( 11 ) de commande pour l'actionnement d'un commutateur ( 6 ) DIP monté sur le module ( 4 ) plat, et complètement dans la deuxième position d'encliquetage, notamment avec sortie d'une ligne ( 7 ) de connexion du module ( 4 ) plat.

9. Boîtier ( 1 ) de transport l'une des revendications 1 à 8, **caractérisé en ce que** l'un des demi-boîtiers ( 2 ) a une partie ( 10 ) d'introduction, pouvant être introduite dans l'autre demi-boîtier ( 3 ), la paroi ( 3c ) arrière du boîtier de l'autre demi-boîtier ( 3 ) étant efficace dans la deuxième position d'encliquetage comme butée d'insertion.

10. Boîtier ( 1 ) de transport l'une des revendications 1 à 9, **caractérisé en ce que** l'un et/ou l'autre demi-boîtier ( 2, 3 ) ont un élément ( 18, 19 ) à déclique élastique à la manière d'un ressort ou élastique en flexion dans une direction ( y ) de flexion et ayant un oeillet ( 23 ) d'insertion pour une immobilisation par serrage, notamment sur un câble ( 21 ) de connexion relié à la ligne ( 7 ) de connexion du module ( 4 ) plat.

11. Boîtier ( 1 ) de transport suivant la revendication 10, **caractérisé par**
un élément ( 24 ) de butée qui est disposé derrière, dans la direction ( y ) de flexion, l'élément ( 18, 19 ) à déclic et qui est destiné à limiter la course ( b ) de flexion de l'élément ( 18, 19 ) à déclic.

12. Boîtier ( 1 ) de transport suivant la revendication 10 ou 11, **caractérisé en ce que** l'élément ( 18 ) à déclic est formé par deux crochets ( 18a ; 18b ) d'encliquetage opposés entre eux et délimitant l'oeillet ( 23 ) d'insertion.

13. Boîtier ( 1 ) de transport suivant la revendication 12, **caractérisé en ce que** respectivement un élément ( 24 ) de butée est associé à chaque crochet ( 18a, 18b ) d'encliquetage de l'élément ( 18 ) à déclique du côté ( 19 ) arrière du crochet éloigné de l'oeillet ( 23 ) d'insertion.

14. Boîtier ( 1 ) de transport l'une des revendications 10 à 13, **caractérisé en ce que** l'élément ( 18 ) à déclic et/ou l'élément ( 24 ) de butée sont formés sur les demi-boîtiers ( 2, 3 ) respectifs.
